# EUROPEAN PATENT SPECIFICATION

(11) **EP 3 499 657 B1**
(45) Date of publication and mention of the grant of the patent: **17.06.2020**
(21) Application number: 17306757.0
(22) Date of filing: 12.12.2017
(51) Int. Cl.: H01S 5/14, H01S 5/06, H01S 5/10

(54) **WIDELY TUNABLE LASER WITH CROSS-CONNECTED RING RESONATOR**
BREIT ABSTIMMBARER LASER MIT QUERVERBUNDENEM RINGRESONATOR
LASER LARGEMENT ACCORDABLE COMPORTANT UN RÉSONATEUR À ANNEAU INTERCONNECTÉ

(43) Date of publication of application: 19.06.2019
(73) Proprietor: Nokia Solutions and Networks Oy, 02610 Espoo (FI)
(72) Inventor: DUAN, Guang-Hua, 92330 SCEAUX (FR)
(74) Representative: Novagraaf Technologies

(56) References cited:
- CN-A- 106 785 882
- US-A1- 2014 133 511
- US-B1- 9 778 493

## Description

### Field of the Invention

The present invention relates to a reflecting filter for widely tunable lasers and associated widely tunable laser.

### Background

Widely tunable lasers require a large tuning range (>100 nm) and high Side-Mode Suppression Ratio (SMSR). Such a tunable laser is composed of a gain region and a filter, with a large free spectral range (>100 nm), a narrow linewidth (< 0,5 nm) and high extinction ratio (defined as ratio between the transmission at the filter's center wavelength and that at any other wavelength out of the filter's bandwidth) over the tuning range. Moreover the losses of the filter are expected to be low and have low wavelength dependency over the tuning range.

Current widely tunable lasers comprise ring resonators adapted to filter and thus select a particular wavelength. However, none of these widely tunable lasers offers, over a wide wavelength range, a sufficiently high extinction ratio that would guarantee a high SMSR for the tunable laser.

So there is a need for filters with a high extinction ratio over a wide wavelength range that would improve SMSR and improve the performance stability over the wavelength tuning range.

CN 106785882 discloses a high-power dual-port output silicon-based tunable external cavity laser.

### Summary

The present invention proposes a reflecting filter, for widely tunable laser, adapted to filter and reflect an incoming optical signal so as to select a predetermined wavelength λ to solve the prior art drawbacks.

In a first and general aspect, a reflecting filter comprises:
- a bidirectional port;
- an output;
- a first, a second and a third codirectional couplers; and
- a first and second ring resonator adapted to filter optical signals at the predetermined wavelength λ;
wherein
- the bidirectional port is adapted to receive the incoming optical signal and to split it in a first main signal and a second main signal by the first codirectional coupler; then
- the second codirectional coupler is adapted to receive the first main signal and to split the first main signal in a first and second sub-signals;
- the third codirectional coupler is adapted to receive the second main signal and to split the second main signal in a third and fourth sub-signals;
- the first ring resonator is adapted to receive the first sub-signal to filter it at the predetermined wavelength λ to produce a first filtered signal,
- the third codirectional coupler is further adapted to receive the first filtered signal and to send it back to the first codirectional coupler,
- the first codirectional coupler is further adapted to split the first filtered signal received from the third codirectional coupler in two and to send one split signal to the output of the reflecting filter, to forming a first portion of a transmitted signal, and to send the other split signal to the bidirectional port so it goes out of the reflecting filter, to form a first portion of a reflected signal;
- the second ring resonator is adapted to receive the second sub-signal and to filter it at the predetermined wavelength λ to produce a second filtered signal,
- the third codirectional coupler is further adapted to receive the second filtered signal and to send it back to the first codirectional coupler,
- the first codirectional coupler is further adapted to split the second filtered signal received from the third codirectional coupler in two and to send one split signal to the output of the reflecting filter, to form a second portion of the transmitted signal, and to send the other split signal to the bidirectional port so it goes out of the reflecting filter, and to form a second portion of the reflected signal;
- the first ring resonator is further adapted to receive the third sub-signal and to filter it at the predetermined wavelength λ to produce a third filtered signal,
- the second codirectional coupler is further adapted to receive the third filtered signal and to send it back to the first codirectional coupler,
- the first codirectional coupler is further adapted to split the third filtered signal received from the second codirectional coupler in two and to send one split signal to the output of the reflecting filter, to form a third portion of the transmitted signal, and to send the other split signal to the bidirectional port so it goes out of the reflecting filter, and to form a third portion of the reflected signal; and
- the second ring resonator is further adapted to receive the fourth sub-signal and to filter it at the predetermined wavelength λ to produce a fourth filtered signal,
- the second codirectional coupler is further adapted to receive the fourth filtered signal and to send it back to the first codirectional coupler,
- the first codirectional coupler is further adapted to split the fourth filtered signal received from the second codirectional coupler in two and to send one split signal to the output of the reflecting filter, to form a fourth portion of the transmitted signal, and to send the other split signal to the bidirectional port so it goes out of the reflecting filter, and to form a fourth portion of the reflected signal.

Advantageously, the reflecting filter is grown on a platform among III-V material platform, silicon on insulator platform, doped silica platform or silicon nitride platform.

The present invention also proposes an associated widely tunable laser that comprises a partially reflecting mirror, a gain section and a reflecting filter as previously described

Advantageously, the widely tunable laser further comprises the following technical features taken alone or in combination:
- the gain section and the reflecting filter are monolithically integrated on a same substrate;
- the substrate is in silicon and the gain section is in III-V material;
- the partially reflecting mirror is one of the following: a Bragg reflector with a Bragg grating, a loop reflector, a cleaved facet or an etched facet;
- the partially reflecting mirror is one monolithically integrated with the gain section and the reflecting filter on a same substrate

### Brief Description of the Drawings

Some embodiments of apparatus in accordance with embodiments of the present invention are now described, by way of example only, and with reference to the accompagnying drawings, in which :
- Figure 1 schematically illustrates a first embodiment of a reflecting filter;
- Figure 2 schematically illustrates a widely tunable laser comprising a reflecting filter according to this first embodiment;
- Figure 3 schematically illustrates a new embodiment of a reflecting filter according to the invention;
- Figure 4 schematically illustrates a widely tunable laser comprising a reflecting filter according to this new embodiment.

### Description of Embodiments

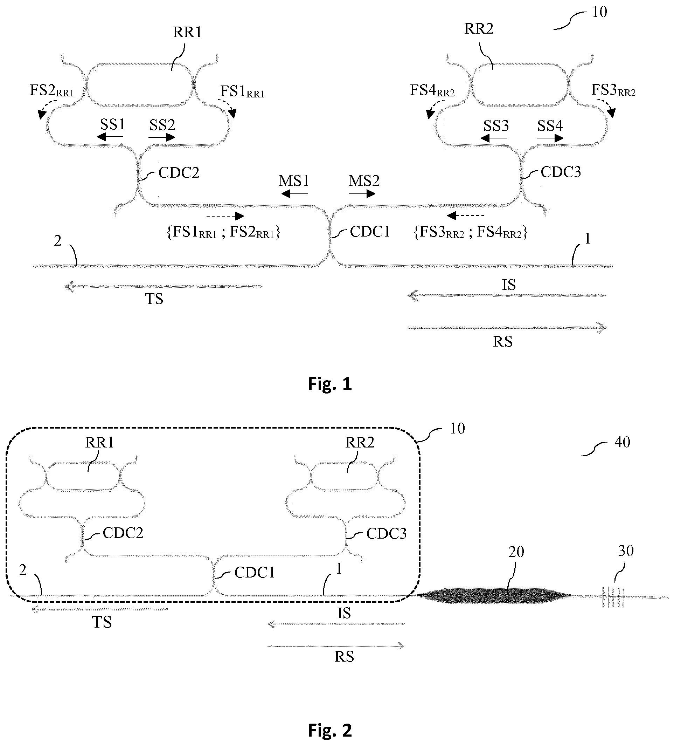

A reflecting filter 10 is schematically illustrated in Figure 1.

This reflecting filter 10 comprises:
- a bidirectional port 1 and an output 2;
- a first, a second and a third codirectional couplers CDC1, CDC2 and CDC3; and
- a first and a second ring resonators RR1 and RR2.

The bidirectional port 1 receives an incoming optical signal IS that is split in a first main signal MS1 and a second main signal MS2 by the first codirectional coupler CDC1.

By codirectional coupler, we mean a directional coupler from which we use both signals propagating in the same direction in the coupling region of the coupler and obtained from an incoming signal.

The first main signal MS1 is sent to the second codirectional coupler CDC2 that splits the first main signal MS1 in two sub-signals SS1 and SS2 that are linked to the first ring resonator RR1.

The optical paths followed by sub-signals SS1, SS2 (which are usually materialized by optical waveguides) and the first ring resonator RR1 form a first ring loop reflector. In fact, the first ring resonator RR1 filters both sub-signals SS1 and SS2 at a predetermined wavelength λ_RR1 and sends the first and second filtered signals obtained FS1_{RR1} and FS2_{RR1} back into the second codirectional coupler CDC2 so that the second codirectional coupler CDC2 sends the first and second filtered signals FS1_{RR1} and FS2_{RR1} back into the first codirectional coupler CDC1. Then, the first codirectional coupler CDC1 sends a part of the first and second filtered signals FS1_{RR1} and FS2_{RR1} into the output 2 of the reflecting filter 10 which forms a transmitted signal TS, and sends the other part into the bidirectional port 1 so that it exits from the reflecting filter by the same way that the incoming optical signal IS originated and forming a reflecting signal RS.

The first filtered signal FS1_{RR1} corresponds to the sub-signal SS1 which has been filtered, at the predetermined wavelength λ_RR1, by the first ring resonator RR1. The second filtered signal FS2_{RR1} corresponds to the sub-signal SS2 which has been filtered, at the predetermined wavelength λ_RR1, by this same first ring resonator RR1.

In the same way, the second main signal MS2 is sent to the third codirectional coupler CDC3 that splits the second main signal MS2 in two sub-signals SS3 and SS4 that are linked to the second ring resonator RR2.

The optical paths followed by sub-beams SB3, SB4 and the second ring resonator RR2 form a second ring loop reflector that filters, at another predetermined wavelength λ_RR2, the sub-beams SB3, SB4 and sends back the third and fourth filtered signals FS3_{RR2} and FS4_{RR2} obtained back into the second codirectional coupler CDC2. A part of the third and fourth filtered signals FS3_{RR2} and FS4_{RR2} is then sent back into the bidirectional port 1 so in the direction from which the incoming optical signal IS originated and corresponds to a second portion of the reflected signal RS. The other part is sent into the output 2 and forms a second portion of the transmitted signal TS.

The third filtered signal FS3_{RR2} corresponds to the sub-signal SS3 which has been filtered, at the predetermined wavelength λ_RR2, by the second ring resonator RR2. The fourth filtered signal FS4_{RR2} corresponds to the sub-signal SS4 which has been filtered, at the predetermined wavelength λ_RR2, by this same second ring resonator RR2.

Thus the reflected signal RS and the transmitted signal TS comprise the four filtered signals FS1_{RR1}, FS2_{RR1}, FS3_{RR2} and FS4_{RR2} in different proportion depending on the characteristics of the codirectional couplers CDC1, CDC2 and CDC3.

So it is as if the incoming signal IS had been reflected after being filtered, via the filtering and the sort of reflection of the sub-signals SS1, SS2, SS3, SS4, and corresponds after filtering and reflection to the reflected signal RS.

Each ring loop reflector provides a comb of resonance peaks thanks to the ring resonator RR1 and RR2. When one resonance created by the first loop coincides in wavelength with one created by the second loop and when the two resonances are in phase, the total reflection will have high values. Consequently a laser incorporating such a filter can achieve the threshold at a wavelength close to the maximum value of the total reflection.

To realise such a tunable laser, the ring resonators RR1 and RR2 must be tuned to that the first predetermined wavelength λ_RR1 is equal to the second predetermined wavelength λ_RR2 (λ_RR1 = λ_RR2). This can be done through thermal effects or electro-optical effects which allow, thus, the wavelength tuning of the laser.

Figure 2 illustrates a laser 40 incorporating the reflecting filter 10, a gain section 20 and a partially reflecting mirror 30.

However it appears that, with this first tunable laser embodiment 40, the filter's extinction ratio is not sufficiently high to guarantee a high SMSR for the tunable laser. In fact, when one resonance created by the first loop coincides in wavelength with one created by the second loop (so when λ_RR1 = λ_RR2) and when the two resonances are in phase, then the next coincidence between the two resonance combs is out of phase. Consequently, there is destructive interference at this coincidence.

However, the splitting ratio of the first codirectional coupler CDC1, as well as its combining ratio, changes with an amount of more than 10% over a wide wavelength range (100 nm for instance), the two reflected lights {FS1_{RR1} ; FS2_{RR1}} and {FS3_{RR2}, FS4_{RR2}} coming from the passage through the two ring resonators RR1 and RR2 do not have the same amount of amplitude, leading to reduced extinction ratio of the reflecting filter 10, which in turn leads to degraded SMSR of the widely tunable laser 40.

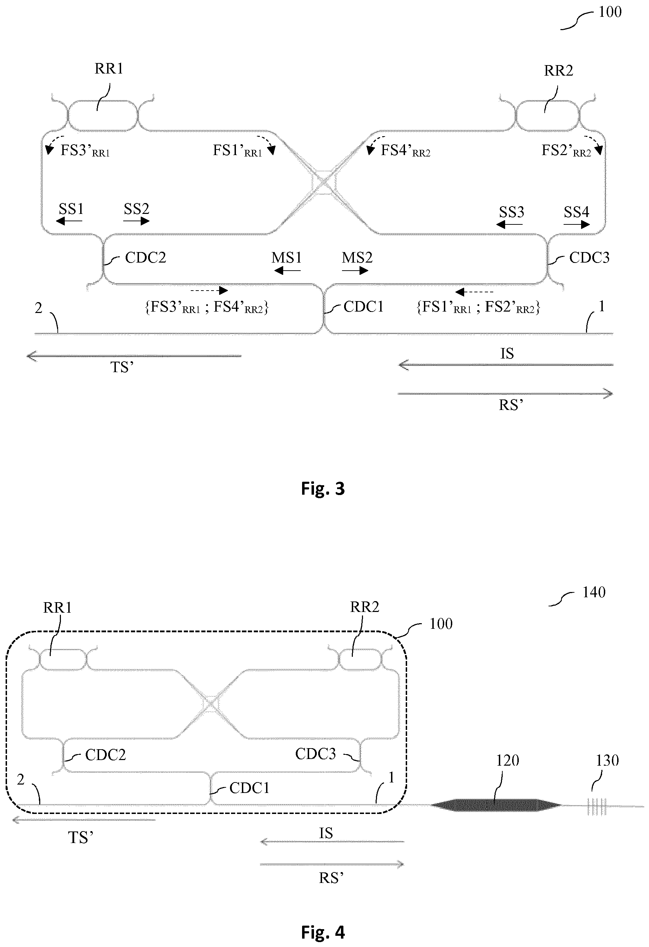

Consequently, an improvement of the reflecting filter 10 is provided by the invention in a new reflecting filter embodiment 100 as illustrated in Figure 3.

In this new embodiment, the basic idea is to use a cross-connected ring resonator configuration, which allows to achieve a better suppression of undesirable resonances over a wide wavelength range. Consequently a widely wavelength tunable laser comprising such a reflecting filter 100 will have a better SMSR.

This new reflecting filter 100 comprises the same elements as the previous reflecting filter 10, which are:
- a bidirectional port 1 and an output 2;
- a first, a second and a third codirectional couplers CDC1, CDC2 and CDC3; and
- a first and a second ring resonators RR1 and RR2.

The bidirectional port 1 receives an incoming optical signal IS that is split in a first main signal MS1 and a second main signal MS2 by the first codirectional coupler CDC1.

The second codirectional coupler CDC2 is adapted to receive the first main signal MS1 and to split the first main signal MS1 in a first and second sub-signals SS1 and SS2. The third codirectional coupler CDC3 is adapted to receive the second main signal MS2 and to split the second main signal MS2 in a third and fourth sub-signals SS3 and SS4.

The difference between the first reflecting filter embodiment 10 and the new reflecting filter embodiment 100 lies in that:
- the first sub-signal SS1 is linked to the first ring resonator RR1 to be filtered at a predetermined wavelength λ_RR1, and the first filtered signal FS1'_{RR1} obtained is sent back into the third codirectional coupler CDC3 in order to be sent back to the first codirectional coupler CDC1 which splits it in two and sends one split signal to the output 2 of the reflecting filter 100, forming a first portion of a transmitted signal TS', and the other split signal to the bidirectional port 1 so it goes out of the reflecting filter (100), and forming a first portion of a reflected signal RS';
- the second sub-signal SS2 is linked to the second ring resonator RR2 to be filtered at a second predetermined wavelength λ_RR2, and the second filtered signal FS2'_{RR2} obtained is sent back into the third codirectional coupler CDC3 in order to be sent back to the first codirectional coupler CDC1 which splits it in two and sends one split signal to the output 2 of the reflecting filter 100, forming a second portion of the transmitted signal TS', and the other split signal to the bidirectional port 1 so it goes out of the reflecting filter (100), and forming a second portion of the reflected signal RS';
- the third sub-signal SS3 is linked to the first ring resonator RR1 to be filtered at a predetermined wavelength λ_RR1, and the third filtered signal FS3'_{RR1} obtained is sent back into the second codirectional coupler CDC2 in order to be sent back to the first codirectional coupler CDC1 which splits it in two and sends one split signal to the output 2 of the reflecting filter 100, forming a third portion of the transmitted signal TS', and the other split signal to the bidirectional port 1 so it goes out of the reflecting filter (100), and forming a third portion of the reflected signal RS'; and
- the fourth sub-signal SS4 is linked to the second ring resonator RR2 to be filtered at a predetermined wavelength λ_RR2, and the fourth filtered signal FS4'_{RR2} obtained is sent back into the second codirectional coupler CDC2 in order to be sent back to the first codirectional coupler CDC1 which splits it in two and sends one split signal to the output 2 of the reflecting filter 100, forming a fourth portion of the transmitted signal TS', and the other split signal to the bidirectional port 1 so it goes out of the reflecting filter (100), and forming a fourth portion of the reflected signal RS'.

Thus the reflected signal RS' and the transmitted signal TS' comprise the four filtered signals FS1'_{RR1}, FS2'_{RR2}, FS3'_{RR1} and FS4'_{RR2} in different proportions depending on the characteristics of the codirectional couplers CDC1, CDC2 and CDC3.

In order to be used in a widely tunable laser, the ring resonators RR1 and RR2 are advantageously tuned so that their resonating wavelengths which correspond to the predetermined wavelengths λ_RR1 and λ_RR2 are equal to a predetermined wavelength λ (λ_RR1 = λ_RR2 = λ), that corresponds to the wavelength desired in the widely tunable laser.

Advantageouly, the reflecting filter 100 can be build on different platforms among III-V (InP, GaAs) material platforms, silicon on insulator platforms, doped silica platforms or silicon nitride platforms for example.

Figure 4 illustrates a widely tunable laser embodiment 140 comprising a partially reflecting mirror 130, a gain section 120 and a reflecting filter 100 as previously described, wherein the laser cavity is formed by the partially reflecting mirror and the reflecting filter.

Advantageously, the gain section 120 and the reflecting filter 100 are monolithically integrated on a same substrate or the same plateform. This substrate or platform can be in silicon and the gain section can be in III-V material for example.

Advantageously, the partially reflecting mirror 130 is one of the following: a Bragg reflector with a Bragg grating, a loop reflector, a cleaved facet or an etched facet. The partially reflecting mirror 130 can also be monolithically integrated with the gain section 120 and the reflecting filter 100.

## Claims

1. A reflecting filter (100), for widely tunable laser, adapted to filter and reflect an incoming optical signal (IS) so as to select a predetermined wavelength λ, the reflecting filter (100) comprising:
- a bidirectional port (1);
- an output (2);
- a first, a second and a third codirectional couplers (CDC1, CDC2, CDC3); and
- a first and second ring resonator (RR1, RR2) adapted to filter optical signals at the predetermined wavelength λ;
wherein
- the bidirectional port (1) is adapted to receive the incoming optical signal (IS) and to split it in a first main signal (MS1) and a second main signal (MS2) by the first codirectional coupler (CDC1); then
- the second codirectional coupler (CDC2) is adapted to receive the first main signal (MS1) and to split the first main signal (MS1) in a first and second sub-signals (SS1, SS2);
- the third codirectional coupler (CDC3) is adapted to receive the second main signal (MS2) and to split the second main signal (MS2) in a third and fourth sub-signals (SS3, SS4); ***characterized in that***
- the first ring resonator (RR1) is adapted to receive the first sub-signal (SS1) and to filter it at the predetermined wavelength λ to produce a first filtered signal (FS1'_{RR1}),
- the third codirectional coupler (CDC3) is further adapted to receive the first filtered signal (FS1'_{RR1}) and to send it back to the first codirectional coupler (CDC1),
- the first codirectional coupler (CDC1) is further adapted to split the first filtered signal (FS1'_{RR1}) received from the third codirectional coupler (CDC3) in two and to send one split signal to the output (2) of the reflecting filter (100), to form a first portion of a transmitted signal (TS'), and to send the other split signal to the bidirectional port (1) so it goes out of the reflecting filter (100), and to form a first portion of a reflected signal (RS');
- the second ring resonator (RR2) is adapted to receive the second sub-signal (SS2) and to filter it at the predetermined wavelength λ to produce a second filtered signal (FS2'_{RR2}),
- the third codirectional coupler (CDC3) is further adapted to receive the second filtered signal (FS2'_{RR2}) and to send it back to the first codirectional coupler (CDC1),
- the first codirectional coupler (CDC1) is further adapted to split the second filtered signal (FS2'_{RR2}) received from the third codirectional coupler (CDC3) in two and to send one split signal to the output (2) of the reflecting filter (100), to form a second portion of the transmitted signal (TS'), and to send the other split signal to the bidirectional port (1) so it goes out of the reflecting filter (100), and to form a second portion of the reflected signal (RS');
- the first ring resonator (RR1) is further adapted to receive the third sub-signal (SS3) and to filter it at the predetermined wavelength λ to produce a third filtered signal (FS3'_{RR1}),
- the second codirectional coupler (CDC2) is further adapted to receive the third filtered signal (FS3'_{RR1}) and to send it back to the first codirectional coupler (CDC1),
- the first codirectional coupler (CDC1) is further adapter to split the third filtered signal (FS3'_{RR1}) received from the second codirectional coupler (CDC2) in two and to send one split signal to the output (2) of the reflecting filter (100), to form a third portion of the transmitted signal (TS'), and to send the other split signal to the bidirectional port (1) so it goes out of the reflecting filter (100), and to form a third portion of the reflected signal (RS'); and
- the second ring resonator (RR2) is further adapted to receive the fourth sub-signal (SS4) and to filter it at the predetermined wavelength λ to produce a fourth filtered signal (FS4'_{RR2}),
- the second codirectional coupler (CDC2) is further adapted to receive the fourth filtered signal (FS4'_{RR2}) and to send it back to the first codirectional coupler (CDC1),
- the first codirectional coupler (CDC1) is further adapted to split the fourth filtered signal (FS4'_{RR2}) received from the second codirectional coupler (CDC2) in two and to send one split signal to the output (2) of the reflecting filter (100), to form a fourth portion of the transmitted signal (TS'), and to send the other split signal to the bidirectional port (1) so it goes out of the reflecting filter (100), and to form a fourth portion of the reflected signal (RS').

2. The reflecting filter (100) according to claim 1 wherein the reflecting filter (100) is grown on a platform among III-V material platform, silicon on insulator platform, doped silica platform or silicon nitride platform.

3. A widely tunable laser (140) comprising a partially reflecting mirror (130), a gain section (120) and a reflecting filter (100) as described in one of the claims 1 and 2, wherein the laser cavity is formed by the partially reflecting mirror (130) and the reflecting filter (100).

4. The widely tunable laser (140) according to claim 3 wherein the gain section (120) and the reflecting filter (100) are monolithically integrated on a same substrate.

5. The widely tunable laser (140) according to claim 4 wherein the substrate is in silicon and the gain section (120) is in III-V material.

6. The widely tunable laser (140) according to one of the claims 3 to 5 wherein the partially reflecting mirror (130) is one of the following: a Bragg reflector with a Bragg grating, a loop reflector, a cleaved facet or an etched facet.

7. The widely tunable laser (140) according to one of the claims 3 to 6 wherein the partially reflecting mirror (130) is one monolithically integrated with the gain section (120) and the reflecting filter (100) on a same substrate.

## Patentansprüche

1. Reflektierendes Filter (100) für einen breit abstimmbaren Laser, das zum Filtern und Reflektieren eines eingehenden optischen Signal (IS) vorgesehen ist, um so eine vorbestimmte Wellenlänge λ auszuwählen, wobei das reflektierende Filter (100) umfasst:
- einen bidirektionalen Port (1);
- einen Ausgang (2),
- einen ersten, einen zweiten und einen dritten codirektionalen Koppler (CDC1, CDC2, CDC3); und
- einen ersten und einen zweiten Ringresonator (RR1, RR2), die zum Filtern von optischen Signalen bei der vorbestimmten Wellenlänge λ vorgesehen sind; wobei
- der bidirektionale Port (1) vorgesehen ist, um das eingehende optische Signal (IS) zu empfangen und es durch den ersten codirektionalen Koppler (CDC1) in ein erstes Hauptsignal (MS1) und ein zweites Hauptsignal (MS2) zu splitten; danach
- der zweite codirektionale Koppler (CDC2) vorgesehen ist, um das erste Hauptsignal (MS1) zu empfangen und das erste Hauptsignal (MS1) in ein erstes und ein zweites Subsignal (SS1, SS2) zu splitten;
- der dritte codirektionale Koppler (CDC3) vorgesehen ist, um das zweite Hauptsignal (MS2) zu empfangen und das zweite Hauptsignal (MS2) in ein drittes und ein viertes Subsignal (SS3, SS4) zu splitten;
**dadurch gekennzeichnet, dass**
- der erste Ringresonator (RR1) vorgesehen ist, um das erste Subsignal (SS1) zu empfangen und es an der vorbestimmten Wellenlänge λ zu filtern, um ein erstes gefiltertes Signal (FS1'_{RR1}) zu produzieren,
- der dritte codirektionale Koppler (CDC3) des Weiteren vorgesehen ist, um das erste gefilterte Signal (FS1'_{RR1}) zu empfangen und es zurück an den ersten codirektionalen Koppler (CDC1) zu senden,
- der erste codirektionale Koppler (CDC1) des Weiteren vorgesehen ist, um das erste gefilterte Signal (FS1'_{RR1}), welches von dem dritten codirektionalen Koppler (CDC3) empfangen wurde, in zwei zu splitten und ein Splitsignal an den Ausgang (2) des reflektierenden Filter (100) zu senden, um einen ersten Anteil eines übermittelten Signals (TS') zu bilden, und um das andere Splitsignal an den bidirektionalen Port (1) zu senden, so dass es aus dem reflektierenden Filter (100) herausgeht, und um einen ersten Anteil eines reflektierten Signals (RS') zu bilden;
- der zweite Ringresonator (RR2) vorgesehen ist, um das zweite Subsignal (SS2) zu empfangen und es an der vorbestimmten Wellenlänge λ zu filtern, um ein zweites gefiltertes Signal (FS2'_{RR2}) zu produzieren,
- der dritte codirektionale Koppler (CDC3) des Weiteren vorgesehen ist, um das zweite gefilterte Signal (FS2'_{RR2}) zu empfangen und es zurück an den ersten codirektionalen Koppler (CDC1) zu senden,
- der erste codirektionale Koppler (CDC1) des Weiteren vorgesehen ist, um das zweite gefilterte Signal (FS2'_{RR2}), welches von dem dritten codirektionalen Koppler (CDC3) empfangen wurde, in zwei zu splitten und ein Splitsignal an den Ausgang (2) des reflektierenden Filters (100) zu senden, um einen zweiten Anteil des übermittelten Signals (TS') zu bilden, und um das andere Splitsignal an den bidirektionalen Port (1) zu senden, so dass es aus dem reflektierenden Filter (100) herausgeht, und um einen zweiten Anteil eines reflektierten Signals (RS') zu bilden;
- der erste Ringresonator (RR1) des Weiteren vorgesehen ist, um das dritte Subsignal (SS3) zu empfangen und es an der vorbestimmten Wellenlänge λ zu filtern, um ein drittes gefiltertes Signal (FS3'_{RR1}) zu produzieren,
- der zweite codirektionale Koppler (CDC2) des Weiteren vorgesehen ist, um das dritte gefilterte Signal (FS3'_{RR1}) zu empfangen und es zurück an den ersten codirektionalen Koppler (CDC1) zu senden,
- der erste codirektionale Koppler (CDC1) des Weiteren vorgesehen ist, um das dritte gefilterte Signal (FS3'_{RR1}), welches von dem zweiten codirektionalen Koppler (CDC2) empfangen wurde, in zwei zu splitten und ein Splitsignal an den Ausgang (2) des reflektierenden Filter (100) zu senden, um einen dritten Anteil des übermittelten Signals (TS') zu bilden, und um das andere Splitsignal an den bidirektionalen Port (1) zu senden, so dass es aus dem reflektierenden Filter (100) herausgeht, und um einen dritten Anteil eines reflektierten Signals (RS') zu bilden; und
- der zweite Ringresonator (RR2) des Weiteren vorgesehen ist, um das vierte Subsignal (SS4) zu empfangen und es an der vorbestimmten Wellenlänge λ zu filtern, um ein viertes gefiltertes Signal (FS4'_{RR2}) zu produzieren,
- der zweite codirektionale Koppler (CDC2) des Weiteren vorgesehen ist, um das vierte gefilterte Signal (FS4'_{RR2}) zu empfangen und es zurück an den ersten codirektionalen Koppler (CDC1) zu senden,
- der erste codirektionale Koppler (CDC1) des Weiteren vorgesehen ist, um das vierte gefilterte Signal (FS4'_{RR2}), welches von dem zweiten codirektionalen Koppler (CDC2) empfangen wurde, in zwei zu splitten und ein Splitsignal an den Ausgang (2) des reflektierenden Filter (100) zu senden, um einen vierten Anteil des übermittelten Signals (TS') zu bilden, und um das andere Splitsignal an den bidirektionalen Port (1) zu senden, so dass es aus dem reflektierenden Filter (100) herausgeht, und um einen vierten Anteil eines reflektierten Signals (RS') zu bilden.

2. Reflektierendes Filter (100) nach Anspruch 1, wobei das reflektierende Filter (100) auf einer Plattform innerhalb einer III-V-Materialplattform, Silicium-auf-Isolator-Plattform, dotierten Siliciumdioxidplattform oder Siliciumnitridplattform gezüchtet wird.

3. Breit abstimmbarer Laser (140), der einen teilreflektierenden Spiegel (130), einen Verstärkerabschnitt (120) und ein reflektierendes Filter (100) wie in einem der Ansprüche 1 und 2 beschrieben umfasst, wobei der Laserhohlraum durch den teilreflektierenden Spiegel (130) und das reflektierende Filter (100) gebildet ist.

4. Breit abstimmbarer Laser (140) nach Anspruch 3, wobei der Verstärkerabschnitt (120) und das reflektierende Filter (100) monolithisch auf demselben Substrat integriert sind.

5. Breit abstimmbarer Laser (140) nach Anspruch 4, wobei das Substrat in Silicium ist und der Verstärkerabschnitt (120) ein III-V-Material ist.

6. Breit abstimmbarer Laser (140) nach einem der Ansprüche 3 bis 5, wobei der teilreflektierende Spiegel (130) einer der folgenden ist: ein Bragg-Reflektor mit einem Bragg-Gitter, ein Schleifenreflektor, eine gespaltene Facette oder eine geätzte Facette.

7. Breit abstimmbarer Laser (140) nach einem der Ansprüche 3 bis 6, wobei der teilreflektierende Spiegel (130) einer ist, der monolithisch in den Verstärkerabschnitt (120) und das reflektierende Filter (100) auf demselben Substrat integriert ist.

## Revendications

1. Filtre réfléchissant (100), pour laser largement accordable, adapté pour filtrer et réfléchir un signal optique entrant (IS) de manière à sélectionner une longueur d'onde λ prédéterminée, le filtre réfléchissant (100) comprenant :
- un port bidirectionnel (1) ;
- une sortie (2) ;
- des premier, deuxième et troisième coupleurs co-directionnels (CDC1, CDC2, CDC3) ; et
- des premier et second résonateurs à anneau (RR1, RR2) adaptés pour filtrer des signaux optiques à la longueur d'onde λ prédéterminée ;
- le port bidirectionnel (1) étant adapté pour recevoir le signal optique entrant (IS) et pour le diviser en un premier signal principal (MS1) et un second signal principal (MS2) par le premier coupleur co-directionnel (CDC1) ; puis
- le deuxième coupleur co-directionnel (CDC2) étant adapté pour recevoir le premier signal principal (MS1) et pour diviser le premier signal principal (MS1) en des premier et deuxième sous-signaux (SS1, SS2) ;
- le troisième coupleur co-directionnel (CDC3) étant adapté pour recevoir le second signal principal (MS2) et pour diviser le second signal principal (MS2) en des troisième et quatrième sous-signaux (SS3, SS4) ; **caractérisé en ce que**
- le premier résonateur à anneau (RR1) est adapté pour recevoir le premier sous-signal (SS1) et le filtrer à la longueur d'onde λ prédéterminée pour produire un premier signal filtré (FS1'_{RR1}),
- le troisième coupleur co-directionnel (CDC3) est en outre adapté pour recevoir le premier signal filtré (FS1'_{RR1}) et pour le renvoyer au premier coupleur co-directionnel (CDC1),
- le premier coupleur co-directionnel (CDC1) est en outre adapté pour diviser en deux le premier signal filtré (FS1'_{RR1}) reçu en provenance du troisième coupleur co-directionnel (CDC3) et pour envoyer un signal divisé à la sortie (2) du filtre réfléchissant (100), pour former une première partie d'un signal transmis (TS'), et pour envoyer l'autre signal divisé au port bidirectionnel (1) afin qu'il sorte du filtre réfléchissant (100), et pour former une première partie d'un signal réfléchi (RS') ;
- le second résonateur à anneau (RR2) est adapté pour recevoir le second sous-signal (SS2) et le filtrer à la longueur d'onde λ prédéterminée pour produire un deuxième signal filtré (FS2'_{RR2}),
- le troisième coupleur co-directionnel (CDC3) est en outre adapté pour recevoir le deuxième signal filtré (FS2'_{RR2}) et le renvoyer au premier coupleur co-directionnel (CDC1),
- le premier coupleur co-directionnel (CDC1) est en outre adapté pour diviser le deuxième signal filtré (FS2'_{RR2}) reçu en provenance du troisième coupleur co-directionnel (CDC3) en deux et pour envoyer un signal divisé à la sortie (2) du filtre réfléchissant (100), pour former une deuxième partie du signal transmis (TS'), et pour envoyer l'autre signal divisé au port bidirectionnel (1) afin qu'il sorte du filtre réfléchissant (100), et pour former une deuxième partie du signal réfléchi (RS') ;
- le premier résonateur à anneau (RR1) est en outre adapté pour recevoir le troisième sous-signal (SS3) et pour le filtrer à la longueur d'onde λ prédéterminée pour produire un troisième signal filtré (FS3'_{RR1}),
- le deuxième coupleur co-directionnel (CDC2) est en outre adapté pour recevoir le troisième signal filtré (FS3'_{RR1}) et le renvoyer au premier coupleur co-directionnel (CDC1),
- le premier coupleur co-directionnel (CDC1) est en outre adapté pour diviser en deux le troisième signal filtré (FS3'_{RR1}) reçu en provenance du deuxième coupleur co-directionnel (CDC2) et pour envoyer un signal divisé à la sortie (2) du filtre réfléchissant (100), pour former une troisième partie du signal transmis (TS'), et pour envoyer l'autre signal divisé au port bidirectionnel (1) afin qu'il sorte du filtre réfléchissant (100), et pour former une troisième partie du signal réfléchi (RS') ; et
- le second résonateur à anneau (RR2) est en outre adapté pour recevoir le quatrième sous-signal (SS4) et le filtrer à la longueur d'onde λ prédéterminée pour produire un quatrième signal filtré (FS4'_{RR2}),
- le deuxième coupleur co-directionnel (CDC2) est en outre adapté pour recevoir le quatrième signal filtré (FS4'_{RR2}) et le renvoyer au premier coupleur co-directionnel (CDC1),
- le premier coupleur co-directionnel (CDC1) est en outre adapté pour diviser en deux le quatrième signal filtré (FS4'_{RR2}) reçu en provenance du deuxième coupleur co-directionnel (CDC2) et pour envoyer un signal divisé à la sortie (2) du filtre réfléchissant (100), pour former une quatrième partie du signal transmis (TS'), et pour envoyer l'autre signal divisé au port bidirectionnel (1) afin qu'il sorte du filtre réfléchissant (100), et pour former une quatrième partie du signal réfléchi (RS').

2. Filtre réfléchissant (100) selon la revendication 1, le filtre réfléchissant (100) étant développé sur une plate-forme parmi une plate-forme de matériau III-V, une plate-forme de silicium sur isolant, une plate-forme en silice dopée et une plate-forme en nitrure de silicium.

3. Laser largement accordable (140) comprenant un miroir partiellement réfléchissant (130), une section de gain (120) et un filtre réfléchissant (100) selon l'une des revendications 1 et 2, la cavité laser étant formée par le miroir partiellement réfléchissant (130) et le filtre réfléchissant (100).

4. Laser largement accordable (140) selon la revendication 3, la section de gain (120) et le filtre réfléchissant (100) étant intégrés de manière monolithique sur un même substrat.

5. Laser largement accordable (140) selon la revendication 4, le substrat étant en silicium et la section de gain (120) étant en matériau III-V.

6. Laser largement accordable (140) selon l'une des revendications 3 à 5, le miroir partiellement réfléchissant (130) étant l'un des éléments suivants : un réflecteur de Bragg avec un réseau de Bragg, un réflecteur en boucle, une facette clivée et une facette gravée.

7. Laser largement accordable (140) selon l'une des revendications 3 à 6, le miroir partiellement réfléchissant (130) étant intégré de manière monolithique avec la section de gain (120) et le filtre réfléchissant (100) sur un même substrat.
